(19) Europäisches Patentamt / European Patent Office / Office européen des brevets

(11) **EP 2 678 942 B1**

(12) **FASCICULE DE BREVET EUROPEEN**

(45) Date de publication et mention de la délivrance du brevet:
**06.01.2016 Bulletin 2016/01**

(21) Numéro de dépôt: **12708881.3**

(22) Date de dépôt: **30.01.2012**

(51) Int Cl.:
**H01R 13/62** *(2006.01)*    **G01R 27/26** *(2006.01)*

(86) Numéro de dépôt international:
**PCT/FR2012/050186**

(87) Numéro de publication internationale:
**WO 2012/114009 (30.08.2012 Gazette 2012/35)**

(54) **DISPOSITIF ET PROCEDE D'INTERCONNEXION DE SYSTEMES ELECTRONIQUES A DES POTENTIELS DE REFERENCE DIFFERENTS**

**VORRICHTUNG UND VERFAHREN ZUR VERNETZUNG ELEKTRONISCHER SYSTEME MIT VERSCHIEDENEN REFERENZPOTENTIALEN**

**DEVICE AND METHOD FOR INTERCONNECTING ELECTRONIC SYSTEMS HAVING DIFFERENT REFERENCE POTENTIALS**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.02.2011  FR 1151390**

(43) Date de publication de la demande:
**01.01.2014  Bulletin 2014/01**

(73) Titulaire: **Nanotec Solution
30900 Nîmes (FR)**

(72) Inventeurs:
• **BLONDIN, Christophe
  F-30900 Nîmes (FR)**
• **NEEL, Christian
  F-30900 Nîmes (FR)**

(74) Mandataire: **Pontet Allano & Associes
Parc Les Algorithmes, Bâtiment Platon
CS 70003 Saint-Aubin
91192 Gif-sur-Yvette Cedex (FR)**

(56) Documents cités:
EP-A1- 2 101 408       US-A1- 2001 019 608
US-A1- 2003 048 150

## Description

### Domaine technique

La présente invention concerne un dispositif et un procédé d'interconnexion de systèmes électroniques à des potentiels de référence différents.

Le domaine de l'invention est plus particulièrement mais de manière non limitative celui des dispositifs électroniques d'isolation.

### Etat de la technique antérieure

De manière générale, les systèmes électroniques sont référencés par rapport à un potentiel de masse, qui peut être par exemple une référence en tension par rapport à laquelle sont fixées les tensions d'alimentation. Cette masse peut être ou non reliée à la terre.

Dans certains cas, il est nécessaire que des parties ou des sous-systèmes électroniques soient référencés à des potentiels différents du potentiel de masse du système global, et flottants par rapport à ce dernier. On rencontre ce cas de figure par exemple dans des systèmes de mesure, pour s'affranchir de perturbations électriques sources de bruit.

Parfois, la partie flottante n'est pas totalement séparée du reste du système par une isolation galvanique, mais elle est flottante uniquement pour des fréquences élevées, ou autour d'une fréquence de travail.

Des dispositions particulières sont nécessaires pour pouvoir alimenter électriquement un sous-système flottant et transmettre des signaux analogiques et/ou numériques entre ce système flottant et la partie référencée au potentiel de masse.

On rencontre ce cas de figure par exemple dans le document FR 2 756 048 de Rozière qui divulgue un système de mesure capacitif. Le circuit de détection comprend une partie flottante à haute fréquence dont le potentiel de référence oscille par rapport à la masse du système global à une fréquence d'oscillation.

Les tensions d'alimentations sont transmises à la partie flottante par l'intermédiaire de bobines d'inductance ou selfs de choc placées en série sur les lignes de telle sorte à présenter une impédance élevée à la fréquence d'oscillation du potentiel de référence flottant.

Le même principe peut être utilisé pour transmettre des signaux numériques ou analogiques comme décrit dans le document US 2001/0019608 A1.

On peut également transmettre des signaux entre les parties flottantes et non flottantes par d'autres moyens connus tels que les amplificateurs différentiels, les optocoupleurs, ou des moyens de transmission par ondes radiofréquences.

Les fonctions électroniques doivent souvent être réalisées sous la forme de circuits électroniques intégrés avec un encombrement et une consommation électrique minimale. C'est particulièrement vrai pour les systèmes de mesure capacitifs qui sont de plus en plus utilisés pour réaliser des interfaces tactiles de systèmes portables (téléphones, ordinateurs, ...).

Dans ce contexte, les moyens connus pour transmettre des signaux entre les parties flottantes et non flottantes présentent des inconvénients gênants, tels qu'un encombrement et une consommation élevée.

Le but de la présente invention est de proposer un dispositif permettant d'interconnecter des systèmes électroniques flottants avec des systèmes référencés à la masse, qui consomment un minimum d'énergie et puissent être réalisés sous un faible encombrement.

### Exposé de l'invention

Cet objectif est atteint avec un dispositif d'interconnexion de systèmes électroniques avec des potentiels de référence séparés par une différence de potentiel alternative, comprenant une pluralité de liaisons électriques aptes à relier électriquement lesdits systèmes électroniques, et des bobines d'inductance placées en série sur lesdites liaisons électriques, caractérisé en ce que lesdites bobines d'inductance sont couplées électro-magnétiquement et comprennent des bobinages disposés autour d'un noyau ferromagnétique commun.

Le dispositif selon l'invention peut comprendre en outre :

- une bobine d'inductance reliant des points aux potentiels de référence des systèmes électroniques ;
- une source de tension alternative d'excitation reliée selon une première extrémité au potentiel de référence d'un premier système électronique.

Suivant des modes de réalisation, le dispositif selon l'invention peut comprendre en outre une source de tension alternative d'excitation reliée selon une seconde extrémité au potentiel de référence d'un second système électronique.

Il peut également comprendre en outre une source de tension alternative d'excitation reliée selon une seconde extrémité à un point de connexion intermédiaire d'une bobine d'inductance.

Suivant d'autres modes de réalisation, le dispositif selon l'invention peut comprendre en outre une bobine d'inductance d'excitation couplée électro-magnétiquement aux bobines d'inductance, et reliée selon une première extrémité au potentiel de référence d'un premier système électronique et selon une seconde extrémité à une source de tension alternative d'excitation.

Le dispositif selon l'invention peut comprendre en outre :

- des bobines d'inductance ayant des inductances sensiblement identiques ;
- des bobines d'inductance dont le couplage électromagnétique est optimisé de telle sorte que les inductances mutuelles entre lesdites bobines d'inductance soient comparables à leurs inductances ;
- au moins un condensateur connecté en parallèle avec au moins une bobine d'inductance ;
- des liaisons électriques aptes à transmettre au moins l'un des signaux suivants : tension d'alimentation, signal numérique, signal analogique.

Le dispositif selon l'invention peut être réalisé selon des technologies d'électronique intégrée, par exemple sous la forme d'un circuit intégré ou d'un ASIC (circuit intégré micro-électronique spécialisé, ou « *Application-Specific Integrated Circuit* » en Anglais).

Il peut être apte à interconnecter des circuits intégrés ou des parties de circuits intégrés.

Suivant un autre aspect, il est proposé un système électronique de mesure capacitive comprenant un premier sous-système référencé électriquement à un potentiel de garde flottant, et un second sous-système référencé électriquement à un potentiel de masse, lesquels potentiels de garde et de masse étant séparés par une différence de potentiel alternative, caractérisé en ce qu'il comprend en outre un dispositif d'interconnexion desdits premiers et second sous-systèmes selon l'une quelconque des revendications précédentes.

Suivant encore un autre aspect, il est proposé un procédé d'interconnexion de systèmes électroniques avec des potentiels de référence séparés par une différence de potentiel alternative, comprenant des étapes :

- d'établissement de liaisons électriques pour relier électriquement lesdits systèmes électroniques,
- d'insertion de bobines d'inductance en série sur lesdites liaisons électriques,

lequel procédé comprenant en outre une étape d'établissement de couplage électromagnétique entre lesdites bobines d'inductance, laquelle comprenant une étape de bobinage de bobines d'inductance autour d'un noyau ferromagnétique commun.

**Description des figures et modes de réalisation**

D'autres avantages et particularités de l'invention apparaîtront à la lecture de la description détaillée de mises en oeuvre et de modes de réalisation nullement limitatifs, et des dessins annexés suivants :

- La figure 1 illustre la mise en oeuvre d'un dispositif selon l'invention pour interconnecter deux systèmes électroniques dont les potentiels de référence sont reliés par un signal périodique,
- la figure 2 illustre un premier mode de réalisation de dispositif selon l'invention, avec une source de tension alternative d'excitation du potentiel flottant qui est reliée aux potentiels de référence d'un système flottant et d'un système référencé à la masse,
- la figure 3 illustre un second mode de réalisation de dispositif selon l'invention, avec une source de tension alternative d'excitation du potentiel flottant qui est reliée au potentiel de référence du système flottant uniquement,
- la figure 4 illustre le second mode de réalisation de dispositif selon l'invention, avec une source de tension alternative d'excitation du potentiel flottant qui est reliée au potentiel de référence du système référencé à la masse uniquement,
- la figure 5 illustre un troisième mode de réalisation de dispositif selon l'invention, avec une source de tension alternative d'excitation du potentiel flottant qui est reliée au potentiel de référence du système flottant, et à un point intermédiaire d'un bobinage d'inductance,
- la figure 6 illustre le troisième mode de réalisation de dispositif selon l'invention, avec une source de tension alternative d'excitation du potentiel flottant qui est reliée au potentiel de référence du système référencé à la masse, et à un point intermédiaire d'un bobinage d'inductance.

On va présenter des exemples de modes de réalisation de dispositifs d'interconnexion selon l'invention pour interconnecter des systèmes électroniques dont les potentiels de référence sont reliés par un signal alternatif périodique (sinusoïdal, carré, triangle, etc.).

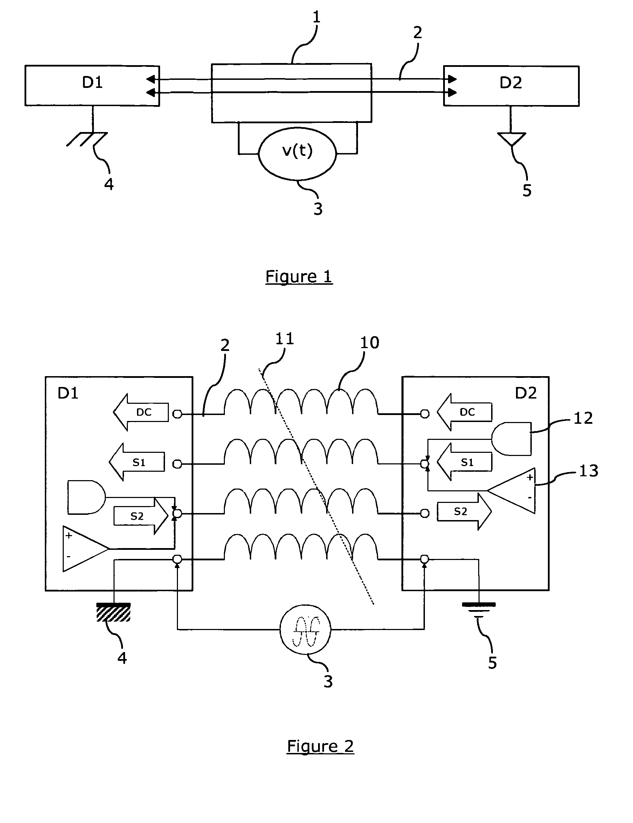

En référence à la figure 1, un dispositif d'interconnexion 1 selon l'invention est mis en oeuvre pour relier des systèmes électroniques D1 et D2.

Dans l'exemple considéré, le système électronique D2 est référencé électriquement à la masse ou à la terre 5. Le système électronique D1 est référencé électriquement à un potentiel de référence flottant 4.

Une source d'excitation 3 de tension alternative relie (directement ou indirectement) la masse 5 et la référence flottante 4, de telle sorte à faire osciller la tension de référence flottante 4 par rapport à la masse 5.

Les systèmes électroniques D1 et D2 sont reliés par des liaisons électriques 2 qui permettent de faire transiter par exemple des tensions d'alimentation, ou des signaux numériques ou analogiques.

Le dispositif d'interconnexion selon l'invention 1 est inséré en série sur ces liaisons électriques 2, de telle sorte à assurer également l'excitation de la référence flottante 4 par la source d'excitation 3.

En référence à la figure 2, selon un premier mode de réalisation, la source d'excitation alternative 3 est reliée à la masse 5 du système électronique D2 d'une part, et au potentiel de référence flottant 4 du système électronique D1 d'autre part.

La source d'excitation alternative 3 peut être elle-même référencée à la masse 5, auquel cas elle excite le potentiel de référence flottant 4. Elle peut également être référencée au potentiel de référence flottant 4, auquel cas elle excite la masse 5 par rapport à ce potentiel de référence flottant 4, ce qui est sensiblement équivalent.

Le dispositif selon l'invention comprend une pluralité de bobines d'inductance 10 placées en série sur les liaisons électriques 2 reliant les systèmes D1 et D2, ainsi qu'entre leurs potentiels de référence respectifs 4, 5. Ces bobines d'inductance 10 sont disposées autour d'un noyau ferromagnétique commun 11 de telle sorte à être couplées magnétiquement (ou électro-magnétiquement).

L'utilisation de bobines d'inductance 10 pour réaliser des isolations électriques à hautes fréquences est connue.

Une bobine d'inductance 10 a une impédance complexe égale, en négligeant la partie résistive, à :

$$Z = jL\omega \hspace{4cm} \text{(Eq. 1)}$$

où $L$ est l'inductance (en Henry, H) et $\omega = 2\pi f$ la pulsation à la fréquence $f$ (en Hz).

Des bobines avec une inductance $L$ suffisamment élevée, placées en série, se comportent sensiblement comme des courts-circuits pour des signaux DC, S1, S2 à transmettre entre les circuits D1 et D2 (à relativement basses fréquences), et comme des circuits ouverts (ou du moins avec une impédance très élevée) à la fréquence de la source d'excitation 3 pour autant que cette fréquence soit suffisamment élevée. Elles permettent ainsi d'isoler fortement les circuits flottants D1 et non flottant D2 aux fréquences élevées et en particulier à la fréquence d'excitation de la source ou de l'oscillateur 3.

Un inconvénient connu de ces dispositifs est leur consommation électrique, qui peut s'avérer excessive dans le cas de systèmes d'électronique intégrée et/ou mis en oeuvre dans des appareils portables.

Pour estimer le courant que doit fournir l'oscillateur 3, on peut remarquer que pour que l'isolation à la fréquence de l'oscillateur 3 (ou en d'autres termes la réjection du signal de l'oscillateur 3) soit satisfaisante, il faut qu'à cette fréquence, les impédances des bobines d'inductance 10 soient bien supérieures aux impédances existant entre, d'une part, les lignes 2 de transfert des alimentations DC et/ou des signaux S1 et S2, et d'autre part, les potentiels de référence 4, 5 respectifs des deux systèmes électroniques D1 et D2. Sur la base de cette approximation, on obtient à la fréquence de l'oscillateur 3 un circuit simplifié constitué de toutes les bobines d'inductance 10 connectées en parallèle aux bornes de cette source d'excitation 3.

Avec $n$ bobines d'inductance 10 d'inductance respective $L_i$, l'oscillateur 3 qui délivre la tension U doit donc débiter un courant :

$$i = \frac{U}{Z} = \frac{U}{jL_{eq}\,\omega} \; , \hspace{3cm} \text{(Eq. 2)}$$

où $L_{eq}$ est l'inductance de toutes les bobines en parallèle. Dans le cas simple où toutes les inductances sont identiques ($L_i = L$), on a :

$$i = n\frac{U}{jL\omega} \hspace{4cm} \text{(Eq. 3)}$$

Ce résultat correspond à un cas représentatif de l'art antérieur où il n'y a aucun couplage entre les bobines 10.

Selon l'invention, les bobines d'inductance 10 sont fortement couplées magnétiquement.

En considérant par exemple quatre bobines 10 d'inductances respectives $L_i$ connectées en parallèle aux bornes d'une source d'excitation 3 délivrant une tension $U$, on a :

$$U = j\,L_1\,\omega\,i_1 + j\,M_{12}\,\omega\,i_2 + j\,M_{13}\,\omega\,i_3 + j\,M_{14}\,\omega\,i_4$$
$$= j\,M_{12}\,\omega\,i_1 + j\,L_2\,\omega\,i_2 + j\,M_{23}\,\omega\,i_3 + j\,M_{24}\,\omega\,i_4$$
$$= j\,M_{13}\,\omega\,i_1 + j\,M_{23}\,\omega\,i_2 + j\,L_3\,\omega\,i_3 + j\,M_{34}\,\omega\,i_4 \qquad (\text{Eq. 4})$$
$$= j\,M_{14}\,\omega\,i_1 + j\,M_{24}\,\omega\,i_2 + j\,M_{34}\,\omega\,i_3 + j\,L_4\,\omega\,i_4$$

Où $i_i$ est le courant circulant dans l'inductance $L_i$ et $M_{ij}$ l'inductance mutuelle due au couplage magnétique entre les bobines d'inductance $i$ et $j$. Pour la démonstration, on peut se placer comme précédemment dans le cas simple où les inductances $L_i$ sont identiques ($L_i = L$) et les inductances mutuelles sont également identiques ($M_{ij} = M$).

Si en plus on se rapproche d'un couplage magnétique (ou électromagnétique) total entre les bobines d'inductance 10, les inductances mutuelles sont sensiblement égales aux inductances propres (L = M) et les expressions de la tension se simplifient comme suit :

$$U = j\,L\,\omega\left(i_1 + i_2 + i_3 + i_4\right).$$

Le courant que doit débiter la source d'excitation 3 devient alors :

$$i = \frac{U}{j\,L\,\omega} \qquad (\text{Eq. 5})$$

Ainsi, selon un résultat remarquable de l'invention, le courant consommé dans toutes les bobines d'inductances 10 couplées électro-magnétiquement est sensiblement égal au courant qui serait consommé dans une seule d'entre elles en l'absence de couplage. Cela revient à dire que pour $n$ bobines d'inductance 10, le courant consommé par un dispositif selon l'invention peut être jusqu'à $n$ fois plus faible que le courant consommé par un dispositif de l'art antérieur, sans couplage entre les bobines.

Selon un autre résultat remarquable de l'invention, il est possible de multiplier le nombre de bobines d'inductances 10 sans affecter notablement le courant consommé. Cet effet est particulièrement avantageux par exemple pour mettre en oeuvre un grand nombre de liaisons numériques 2 parallèles (ou analogiques) entre des systèmes électroniques D1, D2 à des potentiels de référence 4, 5 différents.

Selon encore un autre résultat remarquable, l'invention permet de faire transiter des signaux S1, S1 entre les systèmes D1 et D2 avec des fréquences beaucoup plus élevées que des dispositifs de l'art antérieur dans lesquels les bobines d'inductance ne sont pas couplées électro-magnétiquement.

Pour expliquer ce résultat, on peut considérer un signal S2 (numérique ou analogique) qui transite du système D1 vers le système D2. Ce signal S2 est transmis au travers d'une première bobine d'inductance 10, et le circuit est refermé au travers d'une seconde bobine d'inductance 10 qui relie les potentiels de référence 4, 5 respectifs des systèmes D1 et D2.

Dans un dispositif de l'art antérieur dans lequel les bobines d'inductance 10 ne sont pas couplées magnétiquement, pour que le signal S2 puisse être transmis dans de bonnes conditions il faut que les impédances des bobines d'inductance 10 en série dans le circuit soient suffisamment faibles, en particulier par rapport à l'impédance d'entrée de la ligne 2 de S2 du côté du système D2. Cette contrainte limite les fréquences maximales admissibles du signal D2.

Dans un dispositif selon l'invention, les bobines d'inductance 10 en série sur le circuit de transmission de S2 sont couplées magnétiquement. On peut considérer qu'il passe dans les deux bobines constituant ce circuit un courant i sensiblement identique mais circulant en sens contraire (du système D1 vers le système D2 dans la ligne 2 correspondant à S2 et de D2 vers D1 entre les potentiels de référence 5 et 4 pour refermer le circuit). L'expression de la tension aux bornes de ces bobines d'inductance 10 est alors :

$$U = j\,L\,\omega\,i - j\,M\,\omega\,i \qquad (\text{Eq. 6})$$

Si comme expliqué précédemment on se rapproche d'un couplage électromagnétique total entre ces bobines d'inductance 10 avec des inductances mutuelles qui sont sensiblement égales aux inductances propres (L=M), alors la tension aux bornes de ces bobines 10 tend vers zéro ($U$ = 0). L'impédance des bobines d'inductance 10 n'affecte plus la transmission des signaux et on peut donc transmettre des signaux à toutes fréquences, et en particulier aux fréquences élevées.

Suivant l'invention, les bobines d'inductances 10 sont réalisées sous la forme d'un bobinage multiple comprenant une pluralité fils conducteurs isolés électriquement entre eux et entourant un noyau ferromagnétique. Le bobinage multiple peut comporter un nombre pratiquement illimité de fils dans la mesure où l'impédance vue par la source d'excitation 3 est sensiblement indépendante du nombre de fils.

Le dispositif de l'invention peut ainsi être très compact, avec une consommation électrique faible par rapport à celle des dispositifs de l'art antérieur.

Il a également l'avantage de permettre des réalisations à faible coût.

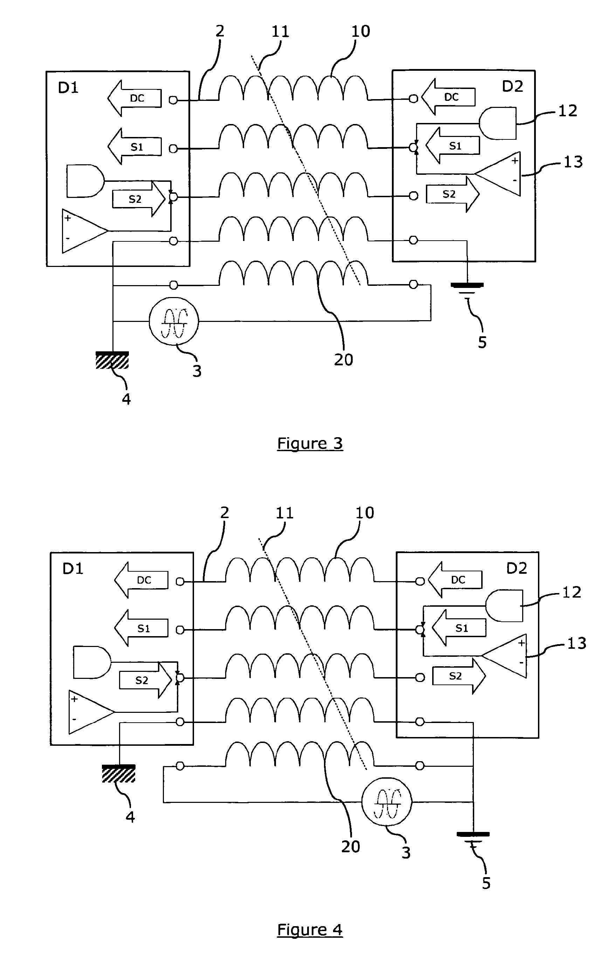

En référence à la figure 3, selon un second mode de réalisation, le dispositif selon l'invention comprend en outre une bobine d'inductance d'excitation 20 connectée aux bornes de la source 3. Cette bobine d'excitation 20 est couplée magnétiquement (ou électro-magnétiquement) avec les autres bobines d'inductances 10 placées en série sur les liaisons électriques 2. Pour cela, elle est disposée (ou bobinée) autour du même noyau ferromagnétique 11 que les autres bobines 10.

La source d'excitation alternative 3 est reliée au potentiel de référence flottant 4 du système électronique D1. Elle n'est pas reliée (du moins directement à sa fréquence d'oscillation) à la masse 5 du système électronique D2.

Cette bobine d'excitation 20, alimentée par la source 3, permet de fixer la différence de potentiel, entre les potentiels de référence 4, 5 des systèmes D1 et D2 par couplage magnétique avec les autres bobines d'inductance 10. On forme ainsi un transformateur dont le primaire est la bobine d'excitation 20 et les secondaires les bobines d'inductances 10.

La figure 4 présente le cas symétrique de celui présenté à la figure 3, correspondant au même mode de réalisation mais dans lequel la source est reliée au potentiel de référence ou de masse 5 du système électronique D2.

Dans ce mode de réalisation, on peut connecter indifféremment la source d'excitation 3 à un potentiel de référence 4, 5 flottant ou non flottant de l'un des systèmes.

Ce mode de réalisation avec une bobine d'excitation 20 permet d'améliorer l'isolation entre la source d'excitation 3 et l'un des systèmes D1 ou D2. Il permet également de créer des différences de potentiel entre les potentiels de référence 4, 5 différentes de la tension de la source d'excitation 3, en mettant en oeuvre une bobine d'excitation 20 avec un nombre de spires différent de celui des bobines de couplage 10.

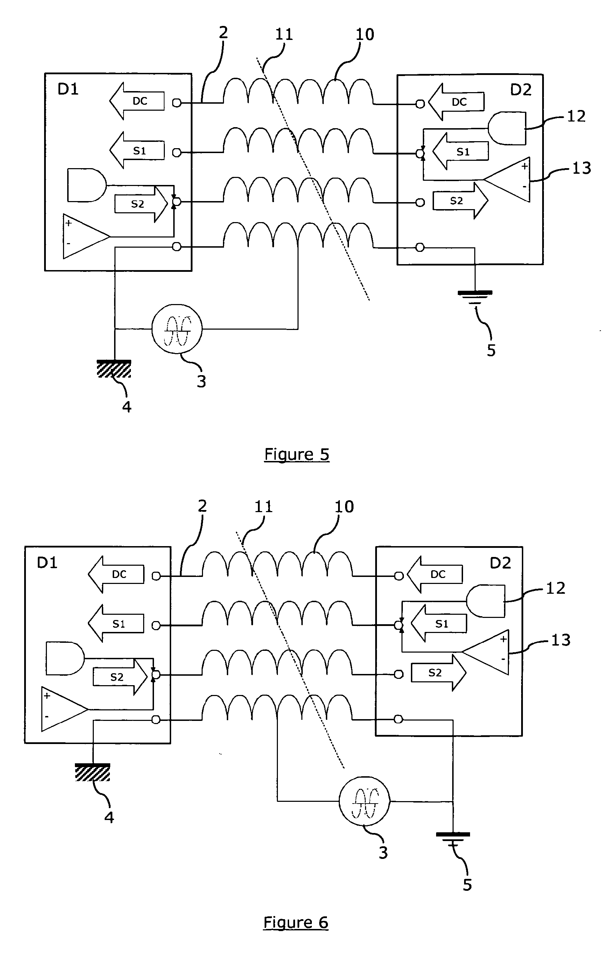

En référence à la figure 5, selon un troisième mode de réalisation, la source d'excitation alternative 3 est reliée au potentiel de référence flottant 4 du système électronique D1, et à un point intermédiaire de la bobine d'inductance 10 reliant les potentiels de référence 4, 5 des deux systèmes D1 et D2.

Cette configuration, qui est proche de celle illustrée à la figure 2, permet d'ajuster l'amplitude de la différence entre les potentiels de référence 4 et 5 des deux systèmes D1 et D2 en utilisant une source d'excitation 3 délivrant une tension périodique d'amplitude fixe. En effet, les bobines d'inductance 10 apparaissent, du point de vue des points aux potentiels de référence 4, 5 et à hautes fréquences, comme connectées en parallèle, et la bobine 10 à laquelle la source est reliée en un point milieu se comporte comme un pont diviseur d'impédance. On peut faire varier l'amplitude de la différence entre les potentiels de référence 4 et 5 en faisant varier la position du point de connexion de la source 3, ou en d'autres termes la valeur relative des inductances de part et d'autre de ce point.

La figure 6 présente le cas symétrique de celui présenté à la figure 5, correspondant au même mode de réalisation mais dans lequel la source est reliée au potentiel de référence ou de masse 5 du système électronique D2.

Dans ce mode de réalisation, on peut également connecter indifféremment la source d'excitation 3 à un potentiel de référence 4, 5 flottant ou non flottant de l'un des systèmes.

Suivant une variante applicable à tous les modes de réalisation, il est possible de rajouter une ou plusieurs capacités ou condensateurs en parallèle avec une ou plusieurs bobines d'inductance 10 entre les systèmes D1 et D2. Il est également possible de placer un condensateur en parallèle sur une bobine d'excitation 20.

On forme ainsi des circuits résonnants dont les fréquences de résonnance peuvent être avantageusement ajustées pour être sensiblement identiques aux fréquences de la source d'excitation 3.

On augmente ainsi considérablement les impédances telles que vues par la source 3 et entre les systèmes D1 et D2 aux fréquences de résonnance, ce qui a pour avantage de réduire encore le courant consommé et d'apporter une meilleure isolation.

Suivant des modes de réalisation, les bobines d'inductance 10 peuvent être réalisées selon tous types de technologies. Elles peuvent notamment être réalisées sous la forme de pistes déposées ou gravées sur un support par un procédé de sérigraphie ou de photolithographie, ou par tout autre procédé utilisé en microélectronique.

Toutes les bobines d'inductance 10 étant couplées magnétiquement, elles peuvent en outre être réalisées dans un encombrement minimum.

Un dispositif selon l'invention peut également être réalisé en utilisant des composants existants pour d'autres applications, tels que des bobines à quatre fils ou des selfs de mode commun.

Le dispositif selon l'invention permet de transmettre tous types de signaux, dans tous sens, entre des systèmes électroniques D1 et D2 dont les potentiels de référence sont reliés par un signal périodique. On peut citer, à titre d'exemples non limitatifs :

- Des tensions d'alimentations continues ou à basse fréquences DC issues de sources de tension référencées au potentiel de référence 5 du système D2. Ces tensions d'alimentation, une fois transférées dans le système D1 au travers des bobines d'inductance 10, deviennent référencées au potentiel de référence 4 du système D1. Il est ainsi possible d'alimenter un système D1 avec une source d'alimentation d'un système D2 et réciproquement ;

- Des signaux numériques ou analogiques de toutes fréquences, issus respectivement de composants logiques 12 ou de composants analogiques 13 du système D2 référencés au travers de leur alimentation au potentiel de référence 5. Ces signaux, une fois transférées dans le système flottant D1 au travers des bobines d'inductance 10, deviennent référencés au potentiel de référence 4 dans le système flottant D1 (et réciproquement) ;
- Des signaux en mode différentiel, numériques ou analogiques ;
- Des signaux transitant sur des liaisons électriques 2 bidirectionnelles.

Des dispositifs selon l'invention peuvent être avantageusement mis en oeuvre dans une grande variété de systèmes électroniques qui nécessitent des masses à des potentiels différents mais pas nécessairement isolés.

Le dispositif selon l'invention est particulièrement bien adapté pour réaliser l'interconnexion entre la partie flottante et la partie référencée à la masse ou à la terre d'un système de mesure capacitif en pont flottant tel que décrit par exemple dans le document FR 2 756 048 de Rozière. En effet, dans cette application, le circuit de détection comprend une partie flottante dont le potentiel de référence, appelé potentiel de garde, oscille par rapport à la masse du système global, ou à la terre. La différence de potentiel alternative entre le potentiel de garde et la masse est générée par un oscillateur. Dans les modes de réalisations décrits dans FR 2 756 048, les interconnexions entre la partie référencée à la garde et la partie référencée à la masse sont réalisées notamment au travers de convertisseurs DC/DC pour transmettre les alimentations à la partie flottante référencée à la garde et d'amplificateurs différentiels pour transmettre les signaux de mesure issus de cette partie flottante.

Cette électronique de mesure capacitive en pont flottant peut être améliorée en y intégrant un dispositif selon l'invention. On peut y mettre en oeuvre par exemple le mode de réalisation décrit à la figure 1. Pour homogénéiser les notations, on considère que le pont capacitif flottant référencé à la garde correspond au système D1 de la figure 1 et la partie référencée à la masse ou à la terre correspond au système D2.

Le dispositif selon l'invention peut s'intégrer dans le pont capacitif de FR 2 756 048 comme suit :

- La source d'excitation 3 est utilisée comme oscillateur. En mode de mesure de capacité, elle est reliée directement d'une part à la garde 4 du système D1 et d'autre part à la masse 5 du système D2 ;
- Les liaisons électriques analogiques et numériques (si l'on intègre par exemple un microprocesseur pour le traitement du signal dans la partie référencée à la garde 4) entre les parties flottantes D1 et non flottantes D2 sont réalisées au travers de bobines d'inductance 10 toutes couplées électro-magnétiquement ;
- La garde 4 et la masse 5 sont reliées au travers d'une bobine d'inductance 10 ;
- Le convertisseur DC/DC est remplacé par des bobines d'inductances 10 permettant de transférer des alimentations générées dans la partie référencée à la masse D2 dans la partie référencée à la garde D1 ;
- L'amplificateur différentiel pour la transmission du signal de mesure (ainsi que d'autres éventuels moyens de transmission de signaux) est également remplacé par une ou des bobine(s) d'inductances couplée(s) 10.

Il est également possible de mettre en oeuvre les autres modes de réalisation de dispositif selon l'invention dans un pont capacitif flottant. Et bien entendu toutes variantes d'implémentation sont possibles dans le cadre de l'invention.

L'utilisation de l'invention dans le pont flottant capacitif de FR 2 756 048 constitue une amélioration de cette technique qui rend plus facile et plus efficace son intégration dans des systèmes électroniques compacts, intégrée et/ou à faible consommation (ou sa réalisation sous la forme de tels circuits) tels que par exemple des interfaces tactiles et sans contact basées sur une détection capacitive pour des smartphones, ou divers systèmes informatiques.

L'invention peut également être mise en oeuvre dans des applications très variées, parmi lesquelles on peut citer notamment :

- tous systèmes de mesure capacitifs ou basés sur un autre principe physique comprenant une partie à un potentiel flottant ;

- des systèmes de commande d'étages de transistors de puissance à effet de champ (FET) ;
- des systèmes comprenant des microprocesseurs connectés par une liaison série ou parallèle ;
- des systèmes comprenant un module de communication USB, Bluetooth™ ou WIFI, et recevant les données d'un autre système par un protocole USB ou une liaison série ;
- des applications où il est nécessaire de limiter des courants parasites alternatifs entre des systèmes et assures une protection électromagnétique (CEM) ;
- toutes applications nécessitant l'interconnexion de systèmes électroniques dont toutes les tensions de référence ou une partie des tensions de référence sont flottantes avec des différences de potentiels alternatives.

Bien sûr, l'invention n'est pas limitée aux exemples qui viennent d'être décrits et de nombreux aménagements peuvent être apportés à ces exemples sans sortir du cadre de l'invention.

**Revendications**

1. Dispositif d'interconnexion pour relier des systèmes électroniques (D1, D2) avec des potentiels de référence respectifs (4, 5) séparés par une différence de potentiel alternative, lequel dispositif d'interconnexion comprenant (i) une pluralité de liaisons électriques (2) aptes à relier électriquement lesdits systèmes électroniques (D1, D2), et (ii) des bobines d'inductance (10) placées en série sur lesdites liaisons électriques (2), **caractérisé en ce que** lesdites bobines d'inductance (10) sont couplées électro-magnétiquement et comprennent des bobinages disposés autour d'un noyau ferromagnétique commun (11).

2. Dispositif selon la revendication 1, **caractérisé en ce qu'**il comprend en outre une bobine d'inductance (10) reliant les potentiels de référence (4, 5) respectifs des systèmes électroniques (D1, D2).

3. Dispositif selon l'une des revendications 1 ou 2, **caractérisé en ce qu'**il comprend en outre une source de tension alternative d'excitation (3) reliée selon une première extrémité au potentiel de référence (4) d'un premier système électronique (D1).

4. Dispositif selon la revendication 3, **caractérisé en ce qu'**il comprend une source de tension alternative d'excitation (3) reliée selon une seconde extrémité au potentiel de référence (5) d'un second système électronique (D2).

5. Dispositif selon la revendication 3, **caractérisé en ce qu'**il comprend une source de tension alternative d'excitation (3) reliée selon une seconde extrémité à un point de connexion intermédiaire d'une bobine d'inductance (10).

6. Dispositif selon la revendication 3, **caractérisé en ce qu'**il comprend en outre une bobine d'inductance d'excitation (20) couplée électro-magnétiquement aux bobines d'inductance (10), et reliée selon une première extrémité au potentiel de référence (4) d'un premier système électronique (D1) et selon une seconde extrémité à une source de tension alternative d'excitation (3).

7. Dispositif selon l'une des revendications précédentes, **caractérisé en ce qu'**il comprend une bobine d'inductance d'excitation (20) et des bobines d'inductance (10) comprenant des bobinages disposés autour d'un noyau ferromagnétique commun (11).

8. Dispositif selon l'une des revendications précédentes, **caractérisé en ce qu'**il comprend des bobines d'inductance (10, 20) ayant des inductances sensiblement identiques.

9. Dispositif selon l'une des revendications précédentes, **caractérisé en ce qu'**il comprend des bobines d'inductance (10, 20) dont le couplage électromagnétique est optimisé de telle sorte que les inductances mutuelles entre lesdites bobines d'inductance (10, 20) soient comparables à leurs inductances.

10. Dispositif selon l'une des revendications précédentes, **caractérisé en ce qu'**il comprend en outre au moins un condensateur connecté en parallèle avec au moins une bobine d'inductance (10, 20).

11. Dispositif selon l'une des revendications précédentes, **caractérisé en ce qu'**il comprend en outre des liaisons électriques (2) aptes à transmettre au moins l'un des signaux suivants : tension d'alimentation, signal numérique, signal analogique.

**12.** Dispositif selon l'une des revendications précédentes, **caractérisé en ce qu'**il est réalisé selon des technologies d'électronique intégrée.

**13.** Dispositif selon l'une des revendications précédentes, **caractérisé en ce qu'**il est apte à interconnecter des circuits intégrés ou des parties de circuits intégrés.

**14.** Système électronique de mesure capacitive comprenant un premier sous-système (D1) référencé électriquement à un potentiel de garde (4) flottant, et un second sous-système (D2) référencé électriquement à un potentiel de masse (5), lesquels potentiels de garde (4) et de masse (5) étant séparés par une différence de potentiel alternative, **caractérisé en ce qu'**il comprend en outre un dispositif d'interconnexion desdits premiers (D1) et second (D2) sous-systèmes selon l'une quelconque des revendications précédentes.

**15.** Procédé d'interconnexion pour relier des systèmes électroniques (D1, D2) avec des potentiels de référence respectifs (4, 5) séparés par une différence de potentiel alternative, lequel procédé d'interconnexion comprenant des étapes :

- d'établissement de liaisons électriques (2) pour relier électriquement lesdits systèmes électroniques (D1, D2),
- d'insertion de bobines d'inductance (10) en série sur lesdites liaisons électriques (2),

**caractérisé en ce qu'**il comprend en outre une étape d'établissement de couplage électromagnétique entre lesdites bobines d'inductance (10), laquelle comprenant une étape de bobinage de bobines d'inductance (10) autour d'un noyau ferromagnétique commun (11).

**Patentansprüche**

**1.** Zusammenschaltungsvorrichtung zum Verbinden von elektronischen Systemen (D1, D2) mit jeweiligen Bezugspotentialen (4, 5), die durch eine Wechselpotentialdifferenz getrennt sind, wobei die Zusammenschaltungsvorrichtung (i) eine Vielzahl von elektrischen Verbindungen (2), welche geeignet sind, die elektronischen Systeme (D1, D2) elektrisch zu verbinden, sowie (ii) Drosselspulen (10), welche an den elektrischen Verbindungen (2) in Reihe angeordnet sind, umfasst, **dadurch gekennzeichnet, dass** die Drosselspulen (10) elektromagnetisch gekoppelt sind und Wicklungen, die um einen gemeinsamen ferromagnetischen Kern (11) herum angeordnet sind, umfassen.

**2.** Vorrichtung nach Anspruch 1, **dadurch gekennzeichnet, dass** sie ferner eine Drosselspule (10), die die jeweiligen Bezugspotentiale (4, 5) der elektronischen Systeme (D1, D2) verbindet, umfasst

**3.** Vorrichtung nach einem der Ansprüche 1 oder 2, **dadurch gekennzeichnet, dass** sie ferner eine Erregerwechselspannungsquelle (3) umfasst, die über ein erstes Ende mit dem Bezugspotential (4) eines ersten elektronischen Systems (D1) verbunden ist.

**4.** Vorrichtung nach Anspruch 3, **dadurch gekennzeichnet, dass** sie eine Erregerwechselspannungsquelle (3) umfasst, die über ein zweites Ende mit dem Bezugspotential (5) eines zweiten elektronischen Systems (D2) verbunden ist.

**5.** Vorrichtung nach Anspruch 3, **dadurch gekennzeichnet, dass** sie eine Erregerwechselspannungsquelle (3) umfasst, die über ein zweites Ende mit einer Zwischenverbindungsstelle einer Drosselspule (10) verbunden ist.

**6.** Vorrichtung nach Anspruch 3, **dadurch gekennzeichnet, dass** sie ferner eine Erregerdrosselspule (20) umfasst, die mit den Drosselspulen (10) elektromagnetisch gekoppelt ist sowie über ein erstes Ende mit dem Bezugspotential (4) eines ersten elektronischen Systems (D1) und über ein zweites Ende mit einer Erregerwechselspannungsquelle (3) verbunden ist.

**7.** Vorrichtung nach einem der vorhergehenden Ansprüche, **dadurch gekennzeichnet, dass** sie eine Erregerdrosselspule (20) und Drosselspulen (10) mit um einen gemeinsamen ferromagnetischen Kern (11) herum angeordneten Wicklungen umfasst.

**8.** Vorrichtung nach einem der vorhergehenden Ansprüche, **dadurch gekennzeichnet, dass** sie Drosselspulen (10, 20), die im Wesentlichen identische Induktivitäten aufweisen, umfasst.

**9.** Vorrichtung nach einem der vorhergehenden Ansprüche, **dadurch gekennzeichnet, dass** sie Drosselspulen (10, 20) umfasst, deren elektromagnetische Kopplung derart optimiert ist, dass die Gegeninduktivitäten zwischen den Drosselspulen (10, 20) mit ihren Induktivitäten vergleichbar sind.

**10.** Vorrichtung nach einem der vorhergehenden Ansprüche, **dadurch gekennzeichnet, dass** sie ferner wenigstens einen Kondensator umfasst, der mit wenigstens einer Drosselspule (10, 20) parallel geschaltet ist.

**11.** Vorrichtung nach einem der vorhergehenden Ansprüche, **dadurch gekennzeichnet, dass** sie ferner elektrische Verbindungen (2) umfasst, die geeignet sind, wenigstens eines der folgenden Signale zu übertragen: Speisespannung, Digitalsignal, Analogsignal.

**12.** Vorrichtung nach einem der vorhergehenden Ansprüche, **dadurch gekennzeichnet, dass** sie entsprechend Techniken integrierter Elektronik ausgebildet ist.

**13.** Vorrichtung nach einem der vorhergehenden Ansprüche, **dadurch gekennzeichnet, dass** sie geeignet ist, integrierte Schaltkreise oder Teile von integrierten Schaltkreisen zusammenzuschalten.

**14.** Elektronisches System zur kapazitiven Messung, umfassend ein auf ein schwebendes Schutzpotential (4) elektrisch referenziertes erstes Subsystem (D1) und ein auf ein Massepotential (5) elektrisch referenziertes zweites Subsystem (D2), wobei das Schutzpotential (4) und das Massepotential (5) durch eine Wechselpotentialdifferenz getrennt sind, **dadurch gekennzeichnet, dass** es ferner eine Vorrichtung zur Zusammenschaltung des ersten (D1) und des zweiten (D2) Subsystems nach einem der vorhergehenden Ansprüche umfasst.

**15.** Zusammenschaltungsverfahren zum Verbinden von elektronischen Systemen (D1, D2) mit jeweiligen Bezugspotentialen (4, 5), die durch eine Wechselpotentialdifferenz getrennt sind, wobei das Zusammenschaltungsverfahren Schritte umfasst:

- des Einrichtens von elektrischen Verbindungen (2), um die elektronischen Systeme (D1, D2) elektrisch zu verbinden,
- des Einfügens von Drosselspulen (10) in Reihe an den elektrischen Verbindungen (2),

**dadurch gekennzeichnet, dass** es ferner einen Schritt zum Herstellen einer elektromagnetischen Kopplung zwischen den Drosselspulen (10) umfasst, wobei er einen Schritt zum Wickeln von Drosselspulen (10) um einen gemeinsamen ferromagnetischen Kern (11) herum umfasst.

## Claims

**1.** Interconnecting device for connecting electronic systems (D1, D2) with respective reference potentials (4, 5) separated by an alternating potential difference, which interconnecting device comprising (i) a plurality of electrical connections (2) capable of electrically connecting said electronic systems (D1, D2), and (ii) inductance coils (10) placed in series in said electrical connections (2), **characterized in that** said inductance coils (10) are electromagnetically coupled and comprise windings arranged around a common ferromagnetic core (11).

**2.** Device according to claim 1, **characterized in that** it comprises moreover an inductance coil (10) connecting the respective reference potentials (4, 5) of the electronic systems (D1, D2).

**3.** Device according to one of claims 1 or 2, **characterized in that** it comprises moreover a source of alternating excitation voltage (3) connected by a first end to the reference potential (4) of a first electronic system (D1).

**4.** Device according to claim 3, **characterized in that** it comprises a source of alternating excitation voltage (3) connected by a second end to the reference potential (5) of a second electronic system (D2).

**5.** Device according to claim 3, **characterized in that** it comprises a source of alternating excitation voltage (3) connected by a second end to an intermediate connection point of an inductance coil (10).

**6.** Device according to claim 3, **characterized in that** it comprises moreover an excitation inductance coil (20) electromagnetically coupled to the inductance coils (10), and connected by a first end to the reference potential (4) of a first electronic system (D1) and by a second end to a source of alternating excitation voltage (3).

7. Device according to one of the preceding claims, **characterized in that** it comprises an excitation inductance coil (20) and inductance coils (10) comprising windings arranged around a common ferromagnetic core (11).

8. Device according to one of the preceding claims, **characterized in that** it comprises inductance coils (10, 20) having substantially identical inductances.

9. Device according to one of the preceding claims, **characterized in that** it comprises inductance coils (10, 20) of which the electromagnetic coupling is optimised such that the mutual inductances between said inductance coils (10, 20) are comparable to their inductances.

10. Device according to one of the preceding claims, **characterized in that** it comprises moreover at least one capacitor connected in parallel with at least one inductance coil (10, 20).

11. Device according to one of the preceding claims, **characterized in that** it comprises moreover electrical connections (2) capable off transmitting at least one of the following signals: power supply voltage, digital signal, analogue signal.

12. Device according to one of the preceding claims, **characterized in that** it is produced according to integrated electronics technologies.

13. Device according to one of the preceding claims, **characterized in that** it is capable of interconnecting integrated circuits or parts of integrated circuits.

14. Electronic capacitive measuring system comprising a first sub-system (D1), electrically referenced to a floating guard potential (4), and a second sub-system (D2) electrically referenced to a ground potential (5), these guard (4) and ground (5) potentials being separated by an alternating potential difference, **characterized in that** it comprises moreover a device for interconnecting said first (D1) and second (D2) sub-systems according to any one of the preceding claims.

15. Interconnecting method for connecting electronic systems (D1, D2) with respective reference potentials (4, 5) separated by an alternating potential difference, which interconnecting method comprising the steps:

   - of establishing electrical connections (2) for electrically connecting said electronic systems (D1, D2),
   - of insertion of inductance coils (10) in series in said electrical connections (2),

   **characterized in that** it comprises moreover a step of establishing electromagnetic coupling between said inductance coils (10), which comprising a step of winding inductance coils (10) around a common ferromagnetic core (11).

Figure 1

Figure 2

Figure 3

Figure 4

Figure 5

Figure 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2756048

- US 20010019608 A1